# EUROPEAN PATENT SPECIFICATION

(11) **EP 4 057 338 B1**
(45) Date of publication and mention of the grant of the patent: **06.05.2026**
(21) Application number: 21161694.1
(22) Date of filing: 10.03.2021
(51) Int. Cl.: H01L 23/373, H01L 23/495, H01L 23/498, H01L 23/15

(54) **METAL SUBSTRATE STRUCTURE AND METHOD OF MANUFACTURING A METAL SUBSTRATE STRUCTURE FOR A SEMICONDUCTOR POWER MODULE AND SEMICONDUCTOR POWER MODULE**
METALLSUBSTRATSTRUKTUR UND VERFAHREN ZUR HERSTELLUNG EINER METALLSUBSTRATSTRUKTUR FÜR EIN HALBLEITERLEISTUNGSMODUL SOWIE HALBLEITERLEISTUNGSMODUL
STRUCTURE DE SUBSTRAT MÉTALLIQUE ET PROCÉDÉ DE FABRICATION D'UNE STRUCTURE DE SUBSTRAT MÉTALLIQUE POUR UN MODULE DE PUISSANCE SEMI-CONDUCTEUR ET MODULE DE PUISSANCE SEMI-CONDUCTEUR

(43) Date of publication of application: 14.09.2022
(73) Proprietor: Hitachi Energy Ltd, 8050 Zürich (CH)
(72) Inventor: Guillon, David, 8857 Vorderthal (CH); Beyer, Harald, 5600 Lenzburg (CH); Ehrbar, Roman, 8037 Zürich (CH)
(74) Representative: Epping - Hermann - Fischer

(56) References cited:
- EP-A1- 1 909 324
- EP-A2- 2 006 909
- JP-A- 2014 090 103
- JP-A- 2014 112 640
- US-A1- 2016 315 023

## Description

The present disclosure is related to a metal substrate structure for a semiconductor power module and a semiconductor power module for a semiconductor device. The present disclosure is further related to a corresponding manufacturing method for a metal substrate structure.

Conventional insulated metal substrates form technology for low and medium power semiconductor packages with low insulation requirements and low thermal resistance simultaneously. Document JP 2014 090103 A discloses a molded package that includes an insulating sheet. The insulating sheet comprises a bottom layer on one side and extends between islands on the other side. Both, the bottom layer and the islands can be made of metal. The insulating sheet further comprise a resin sheet between the bottom layer and the islands to counteract a short circuit.

Document EP 1 909 324 A1 discloses a lead frame partially having different thicknesses. On a thick portion of lead frame, a special electronic component, such as an LED, for which a high current and heat radiation are required is mounted. Document JP 2014 112640 A discloses a semiconductor device that comprises a metal substrate and an electrically insulating lower layer resin which lies on the metal substrate and is thermally cured. The semiconductor device further comprises an upper layer resin which lies on the lower layer resin and is thermally cured and a lead frame which lies on the upper layer resin. Further semiconductor devices are described in the document EP 2 006 909 A2 and US 2016/315023 A1.

In this respect, it is a challenge to provide a stable metal substrate with reliable functionality.

Embodiments of the disclosure relate to a stable metal substrate structure for a semiconductor power module that enables reliable functioning and contributes to an enhanced module life. Further embodiments relate to a corresponding semiconductor power module for a semiconductor device and a manufacturing method for such a metal substrate structure.

These objects are achieved by the subject-matter of the independent claims. Further developments and embodiments are described in the dependent claims.

According to an embodiment, a metal substrate structure for a semiconductor power module comprises a metal top layer having at least one recess which is limited by an edge of the metal top layer, wherein the metal top layer further comprises at least one stress relief structure in an area adjacent to the edge formed by means of at least one of stamping, etching and cutting. The metal substrate structure further comprises a metal bottom layer and a dielectric layer which is coupled with both the metal top layer and the metal bottom layer and formed in between with respect to a stacking direction. The stress relief structure comprises a structured edge surface formed as predetermined roughness of a surface of the metal top layer with a plurality of protrusions. The dielectric layer comprises a resin material, for example.

By use of the described molded metal substrate structure a semiconductor power module is feasible that enables reliable functioning and an enhanced lifetime even for use in high voltage power module applications with a voltage of at least 0.5 kV, for example. The described metal substrate structure realizes a power module insulated metal substrate including a predetermined circuit metallization structure with stress relief pattern, for example.

The stress relief structure also serves as an anchoring structure for improved adhesion between the metal top layer and the dielectric layer. In addition, the metal substrate structure contributes to an enhanced mechanical stability. Both can contribute to an improved high voltage capability and with respect to partial discharge, for example. The described configuration of the metal substrate structure can also contribute to beneficial functionality in view of medium or low voltage and low cost applications.

It is a recognition in connection with the present disclosure that edges of pattern of circuit metallization are exposed to mechanical and thermo-mechanical stress and may cause voids or cracks which can finally lead to delamination between metallization and a resin sheet and which may result in partial discharge and dielectric breakdown. The stress relief structure of the described metal substrate structure is specifically formed in the area of the edge to absorb or dissipate forces due to mechanical or thermos-mechanical stress, for example. Moreover, a reduction of stress caused by comparably stiff metal can be achieved by the stress relief structure. Alternatively or additionally, the stress relief structure contributes to improve the adhesion between the metal pattern of the metal top layer and the isolating resin of the dielectric layer.

Thus, the stress relief structure, for instances comprising one or more stress relief features, is incorporated intentionally into a peripheral or edge region of circuit metallization pattern of the insulated metal substrate structure.

The metallization is formed by the metal top layer which can be a film and/or a sheet comprising copper and/or aluminum. This can also apply to the metal bottom layer which might be formed as a copper and/or aluminum plate or corresponding alloy or a composite material. The metal top layer is formed with a predetermined structure including the at least one recess by means of stamping, for example. However, there are alternatives for manufacturing of the top metallization as well. Alternatively or additionally, the metal top layer is formed with a predetermined structure by means of at least one of etching and laser cutting of a provided metal sheet, for example.

The dielectric layer can be provided by use of an insulated pre-preg material or by means of molding, for example. The dielectric layer is an epoxy and/or ceramic based dielectric, for example. In case of a molded dielectric layer it can comprise a resin based dielectric material with ceramic filling material, e.g. epoxy, Al2O3, AlN, BN, Si3N4 or SiO2. For example, the dielectric layer is an epoxy with filler. The dielectric layer can be also based on other materials suitable for transfer, injection or compression molding such as bismaleimide, cyanate ester, polyimide and/or silicones. Alternatively or additionally, the dielectric layer can include a ceramic material and/or hydroset material or a material combination of two or more of the aforementioned components. However, there are alternatives for manufacturing or providing the insulating dielectric layer as well.

The at least one recess can realize a penetrating opening through a coherent piece of metal forming the metallization of the metal top layer. Alternatively, the at least one recess forms a groove or a free volume between two separate metal paths, for example. The metal top layer can also comprise a plurality of recesses and/or grooves and/or trenches to form a predetermined metal pattern to prepare a desired metallization on the top of the SMMS. In general, the recess is limited by at least one edge of the metal top layer which comprises the stress relief structure close to the edge.

According to an embodiment of the metal substrate structure the edge or a sidewall of the edge is at least partially embedded or covered by the dielectric layer. For example, this can be realized by molding of the dielectric layer and covering the edge or the sidewall of the metal top layer. This can further include covering or embedding of the stress relief structure at the edge of the metal top layer.

According to an embodiment of the metal substrate structure the stress relief structure comprises a thinned edge formed as a thickness reduction of the metal top layer with respect to the stacking direction. Alternatively or additionally, the stress relief structure can comprise at least one of an oblique edge formed as an oblique side surface and a side surface having a beveled structure at the edge of the metal top layer with respect to the stacking direction. A beveled part of the side surface may also be curved or rounded. With respect to a cross section through the lateral main plain of extent the edge of the metal top layer can also comprise a convex or concave profile or shape in a section or in full.

Additionally, the stress relief structure can comprise a recess formed as a local dimple on a surface of the edge of the metal top layer. Alternatively or additionally, the stress relief structure can comprise a recess formed as a groove on one or more surfaces of the metal top layer.

The stress relief structure is formed on at least one of a top surface, a side surface and a bottom surface of the metal top layer and can comprise one or more stress relief formations. In general, the stress relief structure forms a contour in the area of the edge which differs in part at least from a smooth cuboid wall or edge with flat rectangular surfaces which even has no predetermined rough structure next to an edge.

Insulated metal substrate experiences mechanical or thermos-mechanical stress which occurs on edges of the circuit metallization during temperature cycles, for example. The stress relief structure contributes to avoid a formation of voids or cracks on interfaces between circuit metallization pattern and isolating resin sheet realized by the metal top layer and the dielectric layer, respectively. This further contributes to avoid delamination, finally. Thus, the described metal substrate structure contributes to a reduced risk of partial discharge and finally of dielectric breakdown which could lead to faster ageing or even failing of the corresponding power module. Additionally, the stress relief structure contributes to a reliable protection against humidity or hazardous gases, which may penetrate into the substrate interior. These adverse effects can further result in reduced heat dissipation and thus, the described metal substrate structure further contributes to maintain heat dissipation characteristics and to an enhanced module life at all.

According to an embodiment, a semiconductor power module for a semiconductor device comprises an embodiment of the described metal substrate structure and electronics which is coupled with the metal top layer of the metal substrate structure. The semiconductor power module can further comprise a heat sink which is coupled with the metal bottom layer of the metal substrate structure to dissipate heat during operation of the semiconductor power module. Thus, the semiconductor power module can comprise a separate heat sink. Alternatively or additionally, the metal bottom layer of the metal substrate structure can act as a heat sink itself and can be configured to comprise ribs or protrusion, for example, to provide a beneficial heat dissipation. The metal bottom layer can further act as a baseplate of the semiconductor power module. Moreover, the semiconductor power module can comprise two or more embodiments of the aforementioned metal substrate structure. The electronics may include chips, integrated circuits and/or other devices discrete devices.

According to an embodiment, a method of manufacturing an embodiment of the described metal substrate structure for a semiconductor power module comprises providing a metal top layer having at least one recess which is limited by an edge of the metal top layer, wherein the metal top layer further comprises at least one stress relief structure in an area adjacent to the edge. The metal top layer and the at least one stress relief structure in the area adjacent to the edge are manufactured by means of stamping, etching and/or cutting. The stress relief structure comprises a structured edge surface formed as predetermined roughness of a surface of the metal top layer with a plurality of protrusions. There can also be provided two or more metal top layers and/or a patterned metal top layer. The method further comprises providing a metal bottom layer, and providing a dielectric layer. The method further comprises coupling the layers together such that the dielectric layer is coupled with both the metal top layer and the metal bottom layer in between.

According to an embodiment of the method the steps of providing and coupling the dielectric layer comprises providing a pumpable substance with predetermined material properties. The pumpable substance is a viscous raw material of the dielectric layer to be formed. Thus, according to an embodiment the pumpable substance is an epoxy and/or ceramic based liquid. Alternatively or additionally, the raw material may comprise inorganic filled for improved thermal conductivity and/or CTE adjustment with respect to the metal top layer and/or the metal bottom layer. The method further comprises aligning the metal top layer and the metal bottom layer relative to each other with a predetermined distance in between. The distance will substantially predetermine the later thickness of the dielectric layer. For example, the alignment can be realized by placing the metal top layer onto a release film or liner or another fixation, for example in a mold chase of a molding tool. This enables to precisely position the provided metallization structure of the metal top layer relative to the metal bottom layer and can be useful if the metal top layer comprises separate metal pads due to different potentials of operation, for example.

The method further comprises bringing in the pumpable substance between the aligned metal top layer and the metal bottom layer and thus forming a molded dielectric layer which is coupled with both the metal top layer and the metal bottom layer. The molding can be done by compression molding, transfer molding and/or injection molding, for example. If a release film is used for aligning this can be removed from the top surface of the metallization afterwards.

As a result of that the described semiconductor power module and the described manufacturing method comprise or are related to produce an embodiment of the metal substrate structure, described features and characteristics of the metal substrate structure are also disclosed with respect to the semiconductor power module and the manufacturing method and vice versa.

Exemplary embodiments are explained in the following with the aid of schematic drawings and reference numbers. The figures show:
- Figure 1: embodiment of a semiconductor power module;
- Figures 2-10: embodiments of a metal substrate structure for the semiconductor power module;
- Figure 11: flow chart for a method of manufacturing an embodiment of the metal substrate structure.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in different figures, the description thereof is not repeated for each of the following figures. For the sake of clarity elements might not appear with corresponding reference symbols in all figures possibly.

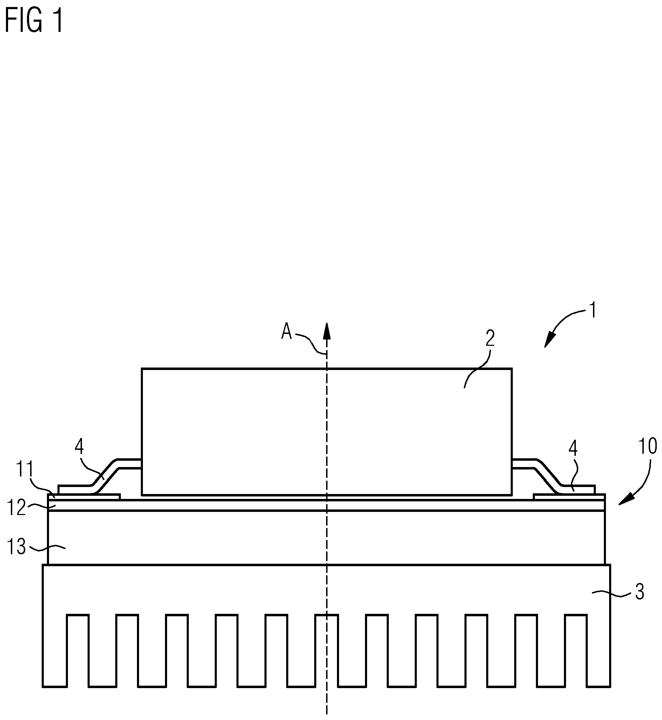

Figure 1 illustrates a side view of an embodiment of a semiconductor power module 1 for a semiconductor device. The semiconductor power module 1 comprises a metal substrate structure 10, electronics 2 which is coupled with the metal substrate structure 10, and a heat sink 3 which is coupled with the metal substrate structure 10 as well. With respect to an illustrated stacking direction A the electronics 2 are coupled with a metal top layer 11 and the heat sink 3 is coupled with a metal bottom layer 13 of the metal substrate structure 10. The metal substrate structure 10 further comprises a dielectric layer 12 formed between the metal top layer 11 and the metal bottom layer 13.

Both, the metal top layer 11 and the metal bottom layer 13 consist of metal or at least comprise metal such as copper and/or aluminum or corresponding alloy. Alternative thermally and/or electrically conductive materials or material combinations can be used instead.

The dielectric layer 12 can be provided as a pre-preg material. The dielectric layer 12 can be realized as an epoxy with filler, for example. The filler can be ceramic like or realized by other inorganic filler. Alternatively or additionally, the dielectric layer 12 comprises a ceramic based insulation layer such as Al2O3, AlN, BN, Si3N4, SiO2. If the dielectric layer 12 is formed by means of molding it can also be based on other materials suitable for transfer, injection and/or compression molding such as bismaleimide, cyanate ester, polyimide and silicones, or might be even based on ceramic materials, such as hydroset materials.

Thus, the metal substrate structure 10 realizes an insulated metal substrate with a structured topside metallization, a metal back side plate and a dielectric insulation layer in between. Pads of the metal top layer 11 are connected to components of the electronics 2 via leads 4. Thus, figure 1 may present an illustration of a chip with wirebond connections. A chip can also be interconnected with pads by bondwires.

The illustrated semiconductor power module 1 can realize a gel-filled power module, wherein the electronics 2 or even the whole top side or even more of the metal substrate structure 10 is embedded in an epoxy and/or gel encapsulation. Such an encapsulation can be done by means of molding afterwards to the manufacturing of the metal substrate structure 10, for example. The described metal substrate structure 10 may be embedded into gel, potting resin and/or mold compound.

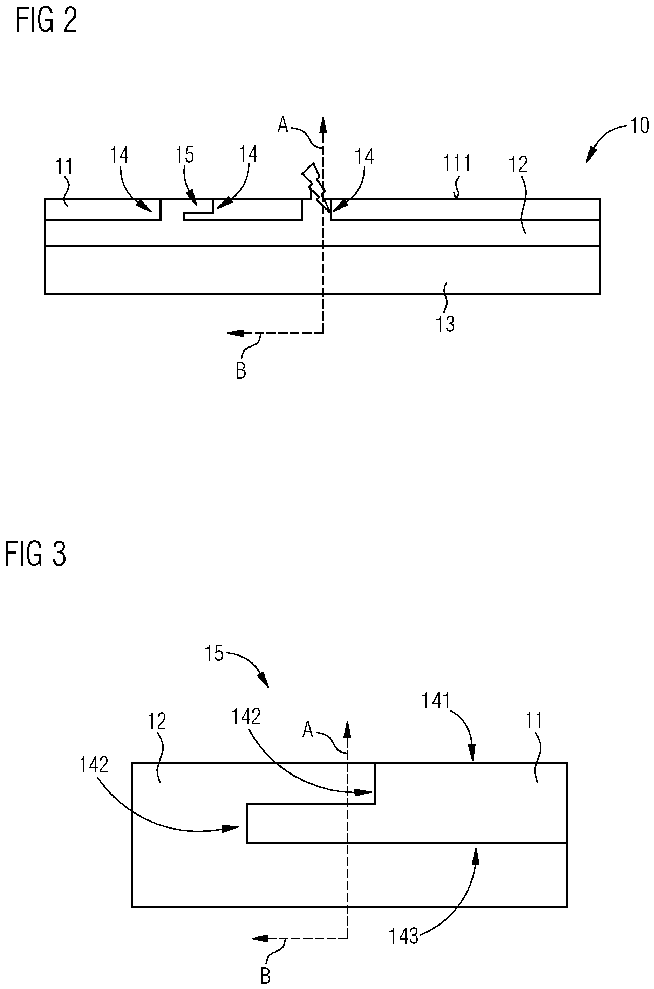

As will be explained with reference to the following figures 2-11 the metal substrate structure 10 enables an enhanced stability and a reliable functioning of the semiconductor power module 1 and further contributes to an increased module life due to a specifically incorporated stress relief structure. The stress relief structure realizes a release structure for improved adhesion of an isolating sheet according to the dielectric layer 12 incorporated to top metallization of the metal top layer 11.

Figure 2 illustrates in a schematic side view an embodiment of the metal substrate structure 10. The metal top layer 11 has two recesses which are limited by corresponding edges 14 of the metal top layer 11. The metal top layer 11 further comprises at least one stress relief structure in an area adjacent to the edge 14. The edges 14 are generally critical areas for mechanical and thermos-mechanical stress which may cause voids and cracks and finally delamination between metallization of the metal top layer 11 and the insulating material of the dielectric layer 12, which may further result in partial discharge and dielectric breakdown (s. illustrated lightning symbol indicating the positions mostly endangered by stress and consequently partial discharge). Due to the intentionally incorporated stress relief structure mechanical and thermo-mechanical stress can be absorbed or dissipated. Moreover, adhesion between the metal top layer 11 and the isolating dielectric layer 12 is improved.

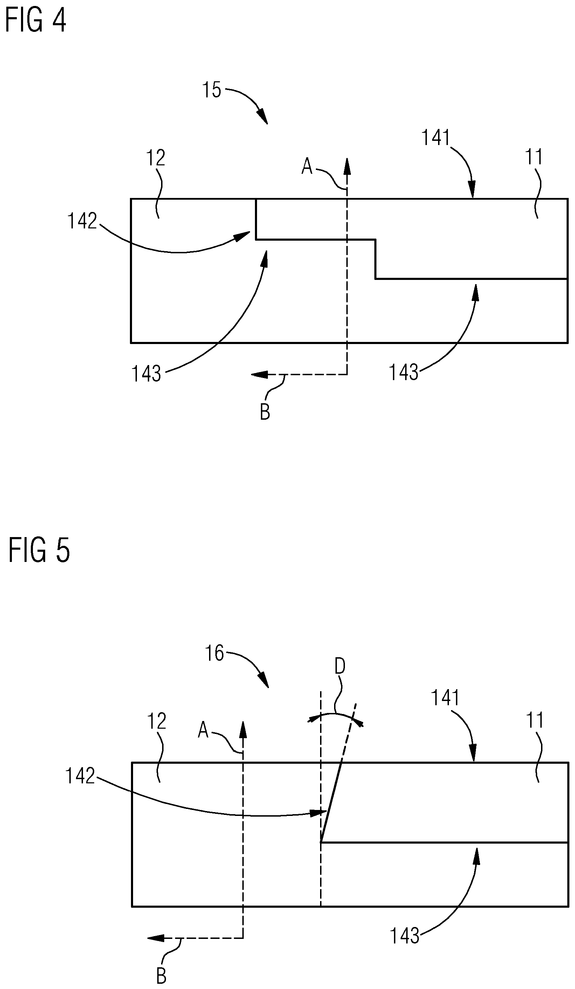

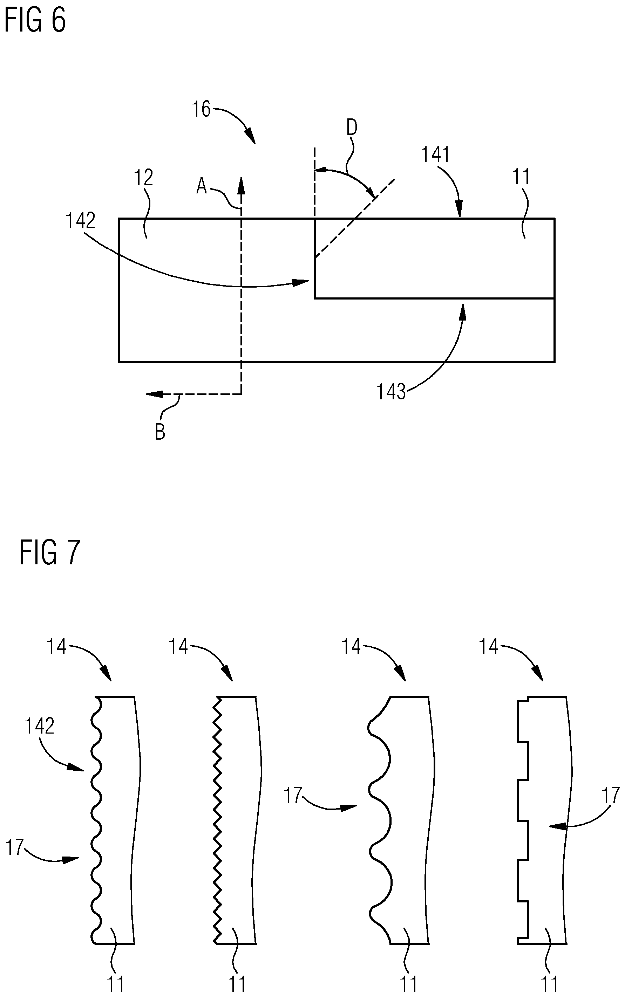

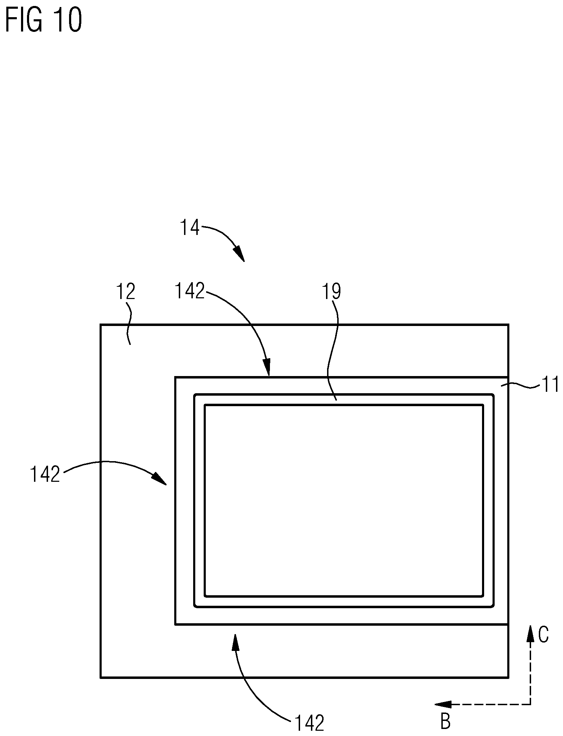

According to the figures 2 to 4 the metal substrate structure 10 comprises a stress relief structure formed as a thinned edge 15. The thinned edge 15 is configured as a thickness reduction which can be incorporated on a top surface 141 and/or a bottom surface 143 of the metal top layer 11 in the area of the edge 14. The thickness is related to the stacking direction A whereas a main area of extent corresponds to lateral directions B and C (see also Fig. 10). Thus, the thinned edge 15 is formed by a local thickness reduction of the circuit metallization pattern of the metal top layer 11. Alternatively or additionally, the stress relief structure can comprise an oblique edge 16 formed as a bevelled side surface 142 of the edge 14 (see Figs. 5 and 6). The side surface 142, a portion therefrom or the bevelled section can comprise a convex or concave contour or sidewall profile to provide an oblique edge 16. Thus, local mechanical stress is reduced by an alternative setup of a local thickness reduction of the metallization pattern. Such a thickness reduction is achieved by the preparation of a completely oblique sidewall (see Fig. 5) or by a bevelled edge portion (see Fig. 6), where only a part of the sidewall is oblique. For example, with respect to the stacking direction A the oblique edge 16 encloses an angle D having a value of 10° up to 60°.

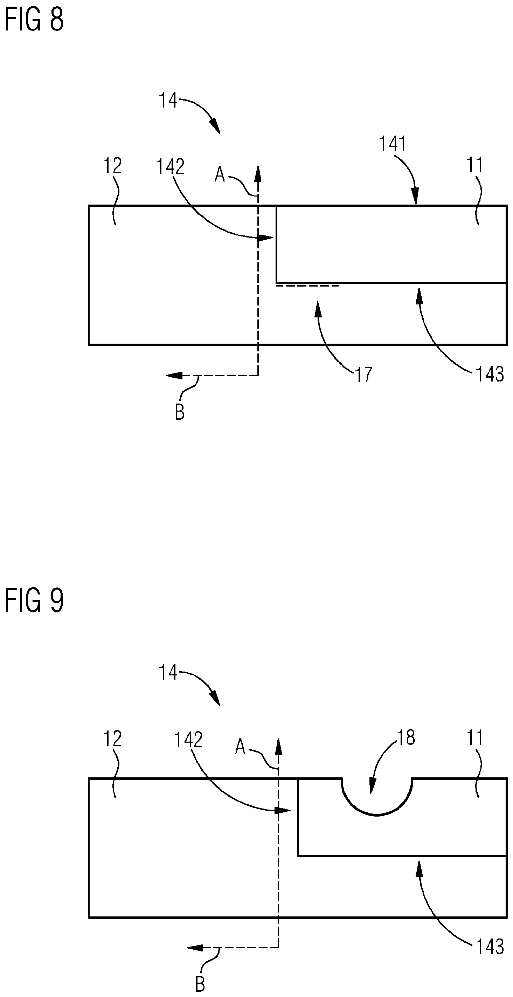

Figure 7 shows the stress relief structure which comprises a structured edge surface 17 formed as predetermined roughness on a side surface 142, top surface 141 and/or bottom surface 143 of the metal top layer 11 in the area of the edge 14 (see also Fig. 8). Such a rough structure differs from a flat and smooth surface without a specifically formed roughness. Figure 7 illustrates options for such a rough contour or shape of the metallization edge 14. The structured edge surface 17 comprises protruding parts, e.g. a sawtooth-structure, providing improved adhesion with isolating resin of the dielectric layer 11, which is compression molded for example.

Moreover, the structured edge surface 17 can comprise a wave structure or a step shape to contribute to an improved adhesion and anchoring between metallization pattern of the metal top layer 11 and the dielectric layer 12. Nevertheless, alternative structures are possible as well. For example, the metal substrate structure 10 comprises a rough structure on a backside of the metal top layer 11 which realizes a structured edge surface 17 on the bottom surface 143 next to the edge 14 (see Fig. 8). Alternatively or additionally, there can be a predetermined roughness formed on a backside or underside of the metal top layer 11 with or without being next to the edge 14, for example. Due to the structured edge surface 17 a specific enhancement of roughness or local structuring of the bottom surface 143 of the metallization pattern of the metal top layer 11 can contribute to an improved adhesion between metallization pattern and a resin sheet of the dielectric layer 12, for example.

According to a further embodiment the stress relief structure can be realized as or can comprise a recess formed as dimple 18 and/or a groove 19 on a side surface 142, top surface 141 and/or bottom surface 143 of the metal top layer 11(see Figs. 9 and 10). Such a groove 19 can comprise a triangular, a concave or a convex shape or profile with respect to a cross section, for example. With respect to a local dimple 18 the edge 14 of the metal top layer 11 will result a reduced stress in the mechanically critical edge region. The dimple can have a round or rectangular shape, but also other types of imprints are possible.

With respect to a groove 19 incorporated on the top surface 141 next to the edge 14 of the metal top layer 11 the edge 14 will result a reduced stress in the mechanically critical edge region as well. The mechanism of stress reduction is similar to the use of dimples and may be formed close to a surrounding boarder of the edge 14 forming a frame-like recess.

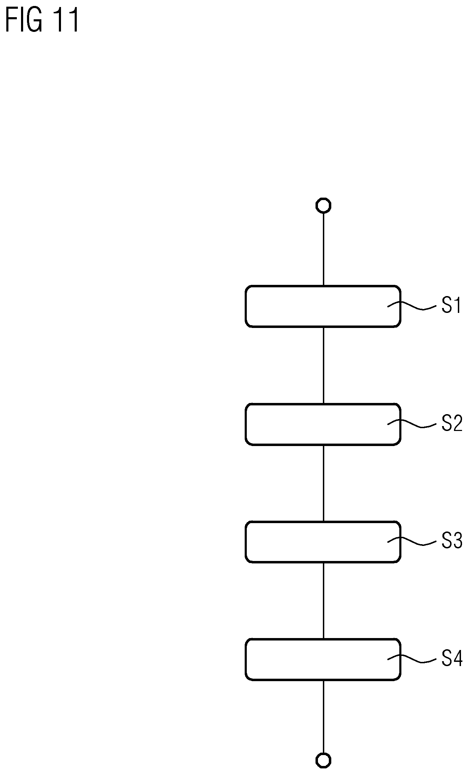

Steps of a corresponding manufacturing method can follow the flow chart as shown in Figure 11. In a step S1 the metal top layer 11 is provided comprising at least one of the described stress relief structures formed in the area of the edge 14 limiting the recess at least one-sided. For example, the step S1 can comprise providing of a raw sheet to form the later metal top layer 11 by means of stamping, etching and/or cutting or another applicable method. Moreover, the metal bottom layer 13 can be provided as well as the dielectric layer 12. The latter can comprise providing a pumpable substance with predetermined material properties which realizes liquid or viscous raw material to form the later dielectric layer 12 by means of injection, transfer and/or compression molding. Alternatively, a lamination process is possible.

In a step S2 the provided layers 11, 12, 13 are coupled together such that the dielectric layer 12 is coupled with both the metal top layer 11 and the metal bottom layer 13 in between.

If the dielectric layer 12 is to be formed by means of molding in step S2 the metal top layer 11 and the metal bottom layer 13 are aligned relative to each other with a predetermined distance in between. This can be done by using a release film, for example, wherein the provided metallization structure of the metal top layer 11 is assembled onto. Afterwards, such a metal top layer release film unit can be positioned relatively to the provided metal bottom layer 13, for example, wherein the metal top layer 11 faces the metal bottom layer 13. Alternatively, a lamination process is possible.

In a step S3 the provided substance is brought in into the free volume between the aligned metal top layer 11 and the metal bottom layer 13 and thus molding of the dielectric layer 12 is processed. This can also include covering or embedding of the side surface 142 of the metal pattern of the metal top layer 11 with the isolating material of dielectric layer 12.

Thus, an embodiment of the metal substrate structure 10 for the semiconductor power module 1 can be manufactured, for example consisting of a stamped metal plate topside realizing the metal top layer 11, an epoxy based molded insulation realizing the dielectric layer 12 and a metal plate bottom side realizing the metal bottom layer 13.

The metal substrate structure 10 provides an improvement with respect to the influence of mechanical or thermo-mechanical stress, especially in the peripheral region or on the edges of the circuit metallization. The stress relief structure enables to suppress or at least to reduce the formation of cracks or voids at the corresponding edge 14 and can contribute to prevent delamination, finally. The different options of stress relief structures can be formed in view of the layout of the edge regions of circuit metallization pattern of the insulated metal substrate structure 10. The stress relief structure is capable to reduce the stress on the interface between metallization pattern and isolating layer and/or to enhance the adhesion between metallization pattern of the metal top layer 11 and resin of the dielectric layer 12. The described formations of the stress relief structure realize at least partly modifications introduced on one or more surfaces 141, 142, 143 or sidewalls next to the edges 14 of one or more circuit metallization pattern. The described formations of the stress relief structure are applicable for both types of insulated metal substrate structures, for a laminated setup and/or for a setup manufactured by stamping and compression molding.

The described embodiments of the stress relief structure which is specifically formed in the area of the edge 14 all counteract adverse effects due to mechanical or thermo-mechanical stress which occurs on the edges 14 of the circuit metallization during temperature cycles, for example. For instances, the stress relief structure contributes to avoid a formation of voids or cracks on interfaces between circuit metallization pattern and isolating resin sheet realized by the metal top layer 11 and the dielectric layer 12, respectively. Thus, the metal substrate structure 10 contributes to a reduced risk of partial discharge and finally of dielectric breakdown.

The metal substrate structure 10 comprises an improved reliability of an insulated metal substrate due to the integration of stress relief structure may further provide several business benefits, which are not only related to the reliability of corresponding substrates itself. An increase of the reliability is directly related to an enhanced power cycling capability of the metal substrate structure 10 and the corresponding semiconductor power module 1. The suppression or at least the reduction of the generation of cracks and voids results in less danger of partial discharge may enhance the voltage range for the use of the insulated metal substrate structure 10. Consequently, a wider use of such insulated metal substrates, which are comparably cost-effective is possible. In addition, the described advantageous also contribute to an enhanced module life of the semiconductor power module 1 at all.

The embodiments shown in the Figures 1 to 7 as stated represent exemplary embodiments of the improved metal substrate structure 10, the semiconductor power module 1 and the manufacturing method for; therefore, they do not constitute a complete list of all embodiments. Actual arrangements and methods may vary from the embodiments shown in terms of metal substrate structures and power modules, for example.

### Reference Signs

- 1: semiconductor power module
- 2: electronics
- 3: heat sink
- 4: leads
- 10: metal substrate
- 11: metal top layer
- 12: dielectric layer
- 13: metal bottom layer
- 14: metal top layer edge
- 141: top surface
- 142: side surface
- 143: bottom surface
- 15: thinned edge
- 16: oblique edge
- 17: structured edge surface
- 18: dimple
- 19: groove

- A: stacking direction
- B: lateral direction
- C: lateral direction
- D: angle of oblique edge
- S(i): steps of a method for manufacturing a metal substrate structure for a semiconductor power module

## Claims

1. A method of manufacturing a metal substrate structure (10) for a semiconductor power module according to one of the claims 3 to 11, comprising:
- providing a metal top layer (11) having at least one recess which is limited by an edge (14) of the metal top layer (11), wherein the metal top layer (11) further comprises at least one stress relief structure in an area adjacent to the edge (14) formed by at least one of stamping, etching and cutting, wherein the stress relief structure comprises a structured edge surface (17) formed as predetermined roughness of a surface (141, 142, 143) of the metal top layer (11) with a plurality of protrusions,
- providing a metal bottom layer (13),
- providing a dielectric layer (12),
- coupling the layers (11, 12, 13) together such that the dielectric layer (12) is coupled with both the metal top layer (11) and the metal bottom layer (13) in between.

2. The method according to claim 1, wherein the steps of providing and coupling the dielectric layer (12) comprises:
- providing a pumpable substance,
- aligning the metal top layer (11) and the metal bottom layer (13) relative to each other with a predetermined distance in between, and
- bringing in the pumpable substance between the aligned metal top layer (11) and the metal bottom layer (13) and thus forming the dielectric layer (12) by means of molding.

3. A metal substrate structure (10) for a semiconductor power module, comprising:
- a metal top layer (11) having at least one recess which is limited by an edge (14) of the metal top layer (11), wherein the metal top layer (11) further comprises at least one stress relief structure in an area adjacent to the edge (14) formed by means of at least one of stamping, etching and cutting,
- a metal bottom layer (13), and
- a dielectric layer (12) which is coupled with both the metal top layer (11) and the metal bottom layer (13) and formed in between with respect to a stacking direction (A), wherein the stress relief structure comprises a structured edge surface (17) formed as predetermined roughness of a surface (141, 142, 143) of the metal top layer (11) with a plurality of protrusions.

4. The metal substrate structure (10) according to claim 3, wherein the edge (14) is at least partially embedded or covered by the dielectric layer (12).

5. The metal substrate structure (10) according to one of the claims 3 or 4, wherein the stress relief structure is formed on at least one of:
- a top surface (141), a side surface (142) and a bottom surface (143) of the metal top layer (11).

6. The metal substrate structure (10) according to one of the claims 3-5, wherein the stress relief structure comprises a thinned edge (15) formed as a thickness reduction of the metal top layer (11) with respect to the stacking direction (A).

7. The metal substrate structure (10) according to one of the claims 3-6, wherein the stress relief structure comprises at least one of an oblique edge (16) and a beveled side surface (142) of the metal top layer (11) with respect to the stacking direction (A).

8. The metal substrate structure (10) according to claim 7, wherein the at least one of the oblique edge (16) and the beveled side surface (142) of the metal top layer (11) comprises a convex or concave shape with respect to a cross section.

9. The metal substrate structure (10) according to one of the claims 3-8, wherein the stress relief structure comprises a recess formed as a dimple (18) on a surface (141, 142, 143) of the metal top layer (11).

10. The metal substrate structure (10) according to one of the claims 3-9, wherein the stress relief structure comprises a recess formed as a groove (19) on a surface (141, 142, 143) of the metal top layer (11).

11. A semiconductor power module (1) for a semiconductor device, comprising:
- a metal substrate structure (10) according to one of the claims 3-10, and
- electronics (2) which is coupled with the metal top layer (11) of the metal substrate structure (10).

## Patentansprüche

1. Verfahren zur Herstellung einer Metallsubstratstruktur (10) für ein Halbleiterleistungsmodul nach einem der Ansprüche 3 bis 11, umfassend:
- Bereitstellen einer obersten Metallschicht (11) mit mindestens einer Ausnehmung, die durch eine Kante (14) der obersten Metallschicht (11) begrenzt ist, wobei die oberste Metallschicht (11) ferner mindestens eine Spannungsentlastungsstruktur in einem Bereich benachbart zur Kante (14) umfasst, die durch mindestens eines von Stanzen, Ätzen und Schneiden ausgebildet ist, wobei die Spannungsentlastungsstruktur eine strukturierte Kantenoberfläche (17) umfasst, die als vorgegebene Rauheit einer Oberfläche (141, 142, 143) der obersten Metallschicht (11) mit einer Vielzahl von Vorsprüngen ausgebildet ist,
- Bereitstellen einer untersten Metallschicht (13),
- Bereitstellen einer dielektrischen Schicht (12),
- Koppeln der Schichten (11, 12, 13) miteinander, sodass die dielektrische Schicht (12) sowohl mit der obersten Metallschicht (11) als auch der untersten Metallschicht (13) dazwischen gekoppelt ist.

2. Verfahren nach Anspruch 1, wobei die Schritte des Bereitstellens und Koppelns der dielektrischen Schicht (12) Folgendes umfassen:
- Bereitstellen einer pumpfähigen Substanz,
- Ausrichten der obersten Metallschicht (11) und der untersten Metallschicht (13) relativ zueinander mit einem vorgegebenen Abstand dazwischen und
- Einbringen der pumpfähigen Substanz zwischen die ausgerichtete oberste Metallschicht (11) und unterste Metallschicht (13) und dadurch Bilden der dielektrischen Schicht (12) mittels Formen.

3. Metallsubstratstruktur (10) für ein Halbleiterleistungsmodul, umfassend:
- eine oberste Metallschicht (11) mit mindestens einer Ausnehmung, die durch eine Kante (14) der obersten Metallschicht (11) begrenzt ist, wobei die oberste Metallschicht (11) ferner mindestens eine Spannungsentlastungsstruktur in einem Bereich benachbart zu der Kante (14) umfasst, die durch Prägen, Ätzen und/oder Schneiden ausgebildet ist,
- eine unterste Metallschicht (13) und
- eine dielektrische Schicht (12), die sowohl mit der obersten Metallschicht (11) als auch der untersten Metallschicht (13) gekoppelt ist und in Bezug auf eine Stapelrichtung (A) dazwischen ausgebildet ist, wobei die Spannungsentlastungsstruktur eine strukturierte Kantenoberfläche (17) umfasst, die als vorgegebene Rauheit einer Oberfläche (141, 142, 143) der obersten Metallschicht (11) mit einer Vielzahl von Vorsprüngen ausgebildet ist.

4. Metallsubstratstruktur (10) nach Anspruch 3, wobei die Kante (14) zumindest teilweise in die dielektrische Schicht (12) eingebettet oder von dieser bedeckt ist.

5. Metallsubstratstruktur (10) nach einem der Ansprüche 3 oder 4, wobei die Spannungsentlastungsstruktur auf mindestens einem von Folgendem ausgebildet ist:
- einer oberen Oberfläche (141), einer Seitenfläche (142) und einer unteren Oberfläche (143) der obersten Metallschicht (11).

6. Metallsubstratstruktur (10) nach einem der Ansprüche 3-5, wobei die Spannungsentlastungsstruktur eine verdünnte Kante (15) umfasst, die als Dickenreduktion der obersten Metallschicht (11) in Bezug auf die Stapelrichtung (A) ausgebildet ist.

7. Metallsubstratstruktur (10) nach einem der Ansprüche 3-6, wobei die Spannungsentlastungsstruktur mindestens eine von einer schrägen Kante (16) und einer abgeschrägte Seitenfläche (142) der obersten Metallschicht (11) in Bezug auf die Stapelrichtung (A) umfasst.

8. Metallsubstratstruktur (10) nach Anspruch 7, wobei die mindestens eine von der schrägen Kante (16) und der abgeschrägte Seitenfläche (142) der obersten Metallschicht (11) eine konvexe oder konkave Form in Bezug auf einen Querschnitt umfasst.

9. Metallsubstratstruktur (10) nach einem der Ansprüche 3-8, wobei die Spannungsentlastungsstruktur eine Ausnehmung umfasst, die als Vertiefung (18) auf einer Oberfläche (141, 142, 143) der obersten Metallschicht (11) ausgebildet ist.

10. Metallsubstratstruktur (10) nach einem der Ansprüche 3-9, wobei die Spannungsentlastungsstruktur eine Ausnehmung umfasst, die als Nut (19) auf einer Oberfläche (141, 142, 143) der obersten Metallschicht (11) ausgebildet ist.

11. Halbleiterleistungsmodul (1) für eine Halbleitervorrichtung, umfassend:
- eine Metallsubstratstruktur (10) nach einem der Ansprüche 3-10 und
- Elektronik (2), die mit der obersten Metallschicht (11) der Metallsubstratstruktur (10) gekoppelt ist.

## Revendications

1. Procédé de fabrication d'une structure de substrat métallique (10) pour un module de puissance semi-conducteur selon l'une des revendications 3 à 11, comprenant :
- la fourniture d'une couche supérieure métallique (11) ayant au moins un évidement qui est limité par un bord (14) de la couche supérieure métallique (11), la couche supérieure métallique (11) comprenant en outre au moins une structure de soulagement de contrainte dans une zone adjacente au bord (14) formée par au moins un processus parmi l'emboutissage, la gravure et la découpe, la structure de soulagement de contrainte comprenant une surface de bord structurée (17) formée en tant que rugosité prédéterminée d'une surface (141, 142, 143) de la couche supérieure métallique (11) avec une pluralité de saillies,
- la fourniture d'une couche inférieure métallique (13),
- la fourniture d'une couche diélectrique (12),
- le couplage des couches (11, 12, 13) ensemble de telle sorte que la couche diélectrique (12) soit couplée à la fois à la couche supérieure métallique (11) et à la couche inférieure métallique (13) entre elles.

2. Procédé selon la revendication 1, dans lequel les étapes consistant à obtenir et à coupler la couche diélectrique (12) comprennent :
- la fourniture d'une substance pompable,
- l'alignement de la couche métallique supérieure (11) et de la couche métallique inférieure (13) l'une relativement à l'autre avec une distance prédéterminée entre elles, et
- la mise en place de la substance pompable entre la couche supérieure métallique (11) alignée et la couche inférieure métallique (13) et ainsi la formation de la couche diélectrique (12) au moyen d'un moulage.

3. Structure de substrat métallique (10) pour un module de puissance semi-conducteur, comprenant :
- une couche supérieure métallique (11) ayant au moins un évidement limité par un bord (14) de la couche supérieure métallique (11), la couche supérieure métallique (11) comprenant en outre au moins une structure de soulagement de contrainte dans une zone adjacente au bord (14) formée par au moins un processus parmi l'emboutissage, la gravure et la découpe,
- une couche métallique inférieure (13), et
- une couche diélectrique (12) qui est couplée à la fois à la couche supérieure métallique (11) et à la couche inférieure métallique (13) et formée entre elles par rapport à une direction d'empilement (A), dans laquelle la structure de soulagement de contrainte comprend une surface de bord structurée (17) formée en tant que rugosité prédéterminée d'une surface (141, 142, 143) de la couche supérieure métallique (11) avec une pluralité de saillies.

4. Structure de substrat métallique (10) selon la revendication 3, dans laquelle le bord (14) est au moins partiellement intégré ou recouvert par la couche diélectrique (12).

5. Structure de substrat métallique (10) selon l'une des revendications 3 ou 4, dans laquelle la structure de soulagement de contrainte est formée sur au moins un élément parmi :
- une surface supérieure (141), une surface latérale (142) et une surface inférieure (143) de la couche supérieure métallique (11).

6. Structure de substrat métallique (10) selon l'une quelconque des revendications 3 à 5, dans laquelle la structure de soulagement de contrainte comprend un bord aminci (15) formé en tant que réduction d'épaisseur de la couche supérieure métallique (11) par rapport à la direction d'empilement (A).

7. Structure de substrat métallique (10) selon l'une quelconque des revendications 3 à 6, dans laquelle la structure de soulagement de contrainte comprend au moins un élément parmi un bord oblique (16) et une surface latérale biseautée (142) de la couche supérieure métallique (11) par rapport à la direction d'empilement (A).

8. Structure de substrat métallique (10) selon la revendication 7, dans laquelle l'au moins un élément parmi le bord oblique (16) et la surface latérale biseautée (142) de la couche supérieure métallique (11) comprend un profil convexe ou concave par rapport à une section transversale.

9. Structure de substrat métallique (10) selon l'une quelconque des revendications 3 à 8, dans laquelle la structure de soulagement de contrainte comprend un évidement formé en tant qu'alvéole (18) sur une surface (141, 142, 143) de la couche supérieure métallique (11).

10. Structure de substrat métallique (10) selon l'une quelconque des revendications 3 à 9, dans laquelle la structure de soulagement de contrainte comprend un évidement formé en tant que rainure (19) sur une surface (141, 142, 143) de la couche supérieure métallique (11).

11. Module de puissance semi-conducteur (1) pour un dispositif semi-conducteur, comprenant :
- une structure de substrat métallique (10) selon l'une des revendications 3 à 10, et
- de l'électronique (2) qui est couplée à la couche supérieure métallique (11) de la structure de substrat métallique (10).
